# FASCICULE DE BREVET EUROPEEN

(11) **EP 1 882 212 B1**
(45) Date de publication et mention de la délivrance du brevet: **09.03.2011**
(21) Numéro de dépôt: 06754937.8
(22) Date de dépôt: 01.05.2006
(51) Int. Cl.: G04B 19/04, G04D 3/00

(54) **ORGANE D'AFFICHAGE ANALOGIQUE EN MATERIAU CRISTALLIN, PIECE D'HORLOGERIE POURVUE D'UN TEL ORGANE D'AFFICHAGE, ET PROCEDE POUR SA FABRICATION**
AUS KRISTALLINEM MATERIAL HERGESTELLTES ANALOGANZEIGEELEMENT, MIT EINEM ANZEIGEELEMENT DIESES TYPS AUSGESTATTETE UHR UND HERSTELLUNGSVERFAHREN DAFÜR
ANALOG DISPLAY ELEMENT MADE OF CRYSTALLINE MATERIAL, TIMEPIECE PROVIDED WITH A DISPLAY ELEMENT OF THIS TYPE AND METHOD FOR THE PRODUCTION THEREOF

(30) Priorité: 12.05.2005 EP 05103979
(43) Date de publication de la demande: 30.01.2008
(60) Demande divisionnaire: 10152831.3
(73) Titulaire: Montres Breguet SA, 1344 L'Abbaye (CH)
(72) Inventeur: MEISTER, Pierre-André, CH-2502 Biel (CH); ZANETTA, André, CH-2000 Neuchâtel (CH); FLEURY, Emmanuel, CH-2740 Moutier (CH); BLONDEAU, Fabien, CH-2054 Chézard-St.-Martin (CH)
(74) Mandataire: Couillard, Yann Luc Raymond
(86) Numéro de dépôt international: PCT/EP2006/061949
(87) Numéro de publication internationale: WO 2006/122873

(56) Documents cités:
- EP-A- 0 555 753
- EP-A- 0 732 635
- EP-A- 1 513 029
- US-A- 5 623 456
- PATENT ABSTRACTS OF JAPAN vol. 011, no. 093 (P-559), 24 mars 1987 (1987-03-24) -& JP 61 245078 A (CITIZEN WATCH CO LTD), 31 octobre 1986 (1986-10-31)

## Description

L'invention concerne un organe d'affichage analogique tel qu'une aiguille de pièce d'horlogerie.

L'invention concerne aussi une pièce d'horlogerie et un procédé de fabrication d'un organe d'affichage.

La fabrication d'une aiguille destinée à être utilisée comme organe d'affichage dans une pièce d'horlogerie est particulièrement complexe, en particulier lorsqu'il s'agit d'une aiguille destinée à équiper une pièce d'horlogerie haut de gamme, pour laquelle l'aiguille doit présenter un aspect de surface particulièrement soigné, éventuellement muni de facettes.

Actuellement, les aiguilles sont fabriquées en laiton, en acier, en or, en aluminium, ou en alliage spécial. Elles peuvent être traitées galvaniquement, recouvertes de peinture, oxydées, ou brutes lorsque le matériau utilisé est l'or. Elles sont généralement réalisées par usinage ou par estampage.

Le document JP 61-245078 enseigne la fabrication d'une aiguille dont le corps est réalisé à partir de gemme, de céramique, de verre ou de saphir synthétique. Afin de fixer un canon au corps de l'aiguille, des dépôts PVD sont réalisés sur le corps puis un soudage entre le canon et les couches déposées est effectué.

Le document EP 0 732 635 divulgue la fabrication de pièces d'horlogerie formées à partir de plaques de silicium mono ou polycristallin par gravage. Afin de modifier la dureté et le coefficient de frottement du corps en silicium, un dépôt CVD en carbone cristallisé est effectué.

Toutefois, les techniques d'usinage et d'estampage de ces matériaux ne permettent pas toujours d'obtenir une précision dimensionnelle satisfaisante, ce qui nécessite des opérations supplémentaires d'ébavurage, de polissage, etc. pour obtenir la forme finale de l'aiguille.

De plus, il est généralement nécessaire d'appliquer sur les aiguilles de multiples traitements pour garantir des états de surface de bonne qualité.

Par ailleurs, les techniques actuelles de fabrication des aiguilles ne permettent pas de réaliser toutes les formes souhaitées, de sorte que la créativité des concepteurs de pièces d'horlogerie s'en trouve bridée.

La présente invention vise à proposer une aiguille qui soit plus facile à fabriquer tout en offrant une grande liberté de conception de sa forme, et qui puisse être fabriquée en série de manière à minimiser les coûts de production.

Dans ce but, l'invention propose un organe d'affichage analogique selon la revendication 1.

L'organe d'affichage selon l'invention présente l'avantage de pouvoir être facilement fabriqué en utilisant des technologies éprouvées dans la microélectronique pour la fabrication de circuits intégrés et dans la micromécanique pour la fabrication de micro-structures.

Le silicium présente l'avantage d'être très léger, puisque sa masse volumique est d'environ 2,49 kg/dm3, ce qui permet de minimiser la masse de l'organe d'affichage, donc les problèmes d'inertie et de balourd, en particulier lorsqu'il a la forme d'une aiguille. De plus, la réduction du balourd et de l'inertie de l'organe d'affichage a une influence favorable sur le dimensionnement des moyens d'entraînement de l'organe d'affichage et sur la consommation énergétique de ces moyens d'entraînement.

Selon d'autres caractéristiques de l'invention :
- le corps principal comporte une portion proximale, dans laquelle est aménagé le trou d'axe, et une portion distale qui constitue le tronçon indicateur de l'aiguille, et la portion distale est liée à la portion proximale par au moins une poutre dont la largeur, dans un plan transversal à l'axe, est inférieure ou égale à cent microns;
- le corps principal comporte, dans son épaisseur, une multitude de trous qui sont parallèles à l'axe d'entraînement et qui ont un diamètre inférieur à cinquante microns;
- la surface supérieure du corps principal comporte des motifs en relief ;
- la surface supérieure du corps principal comporte des facettes ;
- au moins une face du corps principal est pourvue d'un revêtement réalisé dans un matériau différent du corps principal ;
- le revêtement est réalisé en métal ;
- l'organe d'affichage comporte au moins un élément de circuit intégré qui est agencé dans l'épaisseur du corps principal ;
- le matériau cristallin est du silicium monocristallin.

L'invention propose aussi une pièce d'horlogerie caractérisée en ce qu'elle comporte au moins un organe d'affichage analogique selon l'une des caractéristiques précédentes.

L'invention propose encore un procédé de fabrication d'organes d'affichage analogique destinés à équiper des pièces d'horlogerie Selon la revendication 11

Ce procédé est facile à mettre en oeuvre pour réaliser en grande série des pièces précises et légères.

Selon d'autres caractéristiques du procédé selon l'invention :
- au cours de l'étape de micro-usinage de la plaque, des éléments flexibles sont formés sur le corps principal pour permettre le montage de l'organe d'affichage analogique sur l'axe d'entraînement par déformation élastique des éléments flexibles;
- l'étape de micro-usinage est mise en oeuvre de manière à réaliser simultanément plusieurs organes d'affichage analogique dans la même plaque ;
- l'étape de micro-usinage comporte au moins une étape lithographique visant à reproduire sur la plaque les contours d'au moins une portion du corps principal d'un organe d'affichage analogique ;
- le procédé comporte au moins une étape de dépôt d'un revêtement sur au moins une face du corps principal de chaque organe d'affichage analogique ;
- le procédé comporte au moins une étape de micro-usinage de la face supérieure du corps principal pour y réaliser des motifs en relief ;
- le procédé comporte au moins une étape de micro-usinage de la face supérieure du corps principal pour y réaliser des facettes ;
- le matériau cristallin est du silicium monocristallin.

D'autres caractéristiques et avantages de la présente invention apparaîtront plus clairement à la lecture de la description détaillée qui suit, faite en référence aux dessins annexés donnés à titre d'exemple non limitatifs et dans lesquels :
- les figures 1 à 6 sont des vues en section verticale qui illustrent schématiquement plusieurs étapes d'un procédé de fabrication d'aiguilles de pièces d'horlogerie à partir d'une plaque de silicium conformément aux enseignements de l'invention ;
- les figures 7a et 7b sont des vues de dessus qui représentent schématiquement la plaque de silicium à l'étape illustrée par la figure 6 ;
- la figure 8 est une vue de dessus qui représente schématiquement une montre équipée d'au moins une aiguille obtenue par le procédé selon l'invention ;
- la figure 9 est une vue en coupe verticale qui représente schématiquement une aiguille obtenue par le procédé selon l'invention ;
- la figure 10 est une vue de dessus qui représente schématiquement une aiguille obtenue par le procédé selon l'invention et munie de deux facettes longitudinales ;
- la figure 11 est une vue en coupe verticale selon le plan de coupe 11-11 de l'aiguille de la figure 10;
- la figure 12 est une vue de dessus qui représente schématiquement une aiguille obtenue par le procédé selon l'invention et munie de deux poutres de liaison;
- la figure 13 est une vue agrandie d'un tronçon de poutre de la figure 12;
- la figure 14 est une vue en coupe axiale selon le plan 14-14 qui représente de manière agrandie la portion d'extrémité distale de l'aiguille de la figure 12.

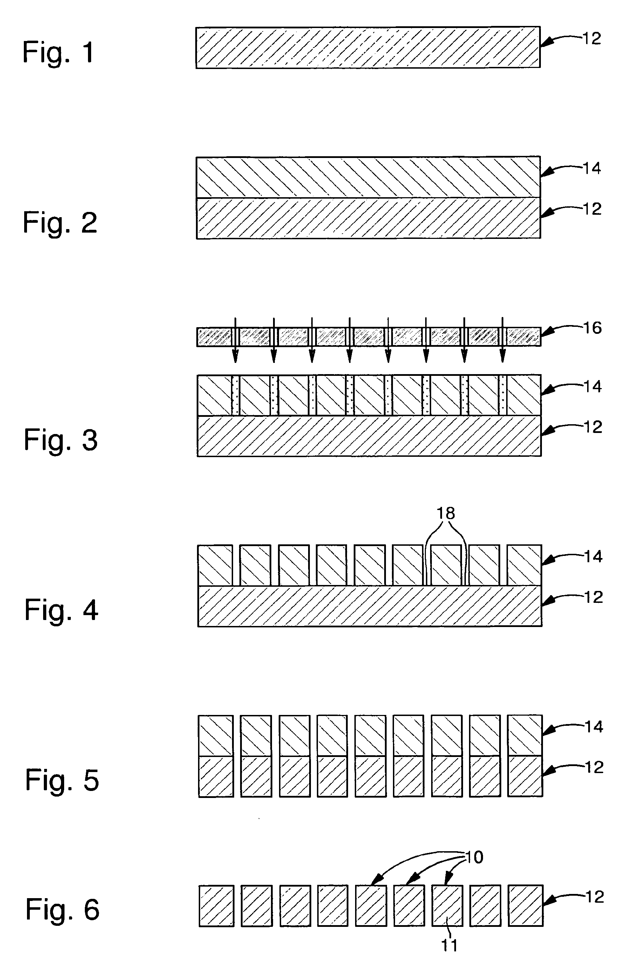

Sur les figures 1 à 7, on a représenté plusieurs étapes d'un procédé pour la fabrication d'organes d'affichage analogique 10 conforme aux enseignements de l'invention.

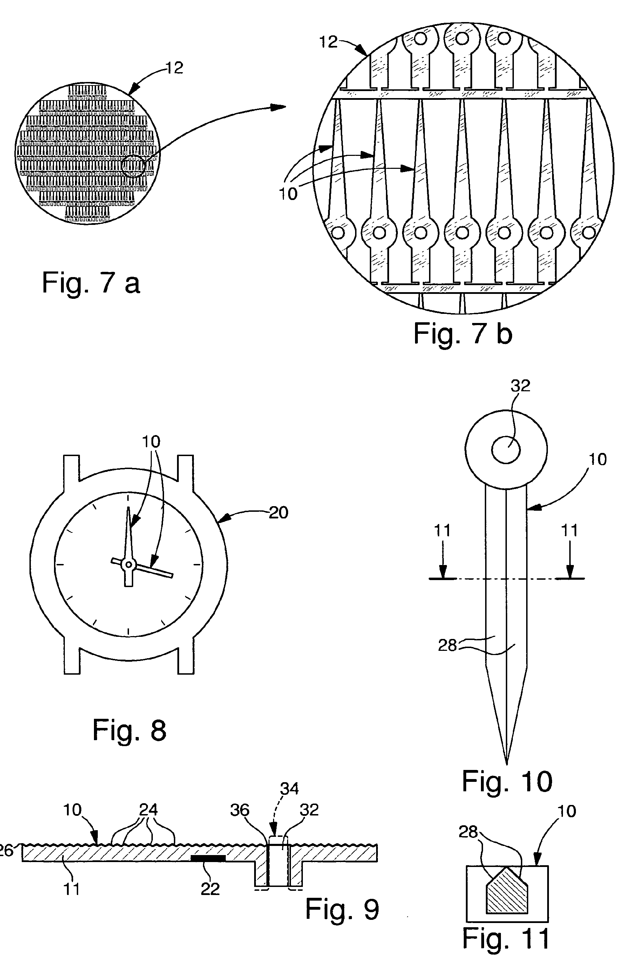

Les organes d'affichage analogique 10 sont ici des aiguilles 10, dont un exemple est représenté schématiquement sur la figure 9.

Conformément aux enseignements de l'invention, chaque aiguille 10 comporte un corps principal 11 qui est réalisé en matériau cristallin à base de silicium.

On entend ici par matériau cristallin à base de silicium un matériau cristallin contenant du silicium tel que le silicium monocristallin, le silicium polycristallin, et le quartz.

De préférence, l'aiguille 10 selon l'invention est micro-usinée dans une plaque de silicium 12 monocristallin telle que celles qui sont utilisées pour la réalisation de circuits électroniques intégrés, ces plaques étant désignées généralement sous le terme de « wafer ».

Avantageusement, une série de plusieurs aiguilles 10 est réalisée dans une même plaque de silicium 12, selon une méthode dite de « batch processing », en faisant appel à des technologies issues du domaine de la microélectronique qui permettent de fabriquer des microstructures mécaniques dans une plaque de silicium 12.

Ces technologies sont déjà mises en oeuvre pour la fabrication de capteurs de pression, d'accéléromètres, de micro-activateurs, de micro-pompes. Elles comportent principalement deux types de procédés de fabrication qui sont les procédés de gravage à sec dits « dry etching », et les procédés de gravage humide dits « wet etching ».

Ces procédés utilisent généralement des techniques de masquage qui permettent d'éliminer localement une couche de matériau d'épaisseur déterminée.

Des procédés de gravage à sec utilisent, par exemple, un faisceau laser ou une source de plasma à haute densité.

Selon un mode de réalisation préféré de l'invention, on utilise des technologies qui permettent de micro-usiner la plaque de silicium 12, de manière à réaliser les aiguilles 10 directement dans l'épaisseur de la plaque de silicium.

L'électropolissage est un exemple de technique utilisée pour le gravage du silicium. Cette technique utilise la propriété pour le silicium monocristallin d'être porosifié par gravage électrochimique anodique dans une solution d'acide fluorhydrique en utilisant une faible densité de courant, cette technique permettant d'éliminer complètement le silicium avec des densités de courant élevées.

Un exemple de mise en oeuvre de la technique d'électropolissage du silicium est décrit dans la publication intitulée "Electrochemical Fabrication of Multiwalled Micro Channels" de R.W. Tjerkstra et al, pages 133-136 des "Proceedings of Micro Total Analysis Systems 98 Workshop", Banff, Canada, dans le cadre de la fabrication de microcanaux coaxiaux dont les parois de séparation sont réalisées en silicium poreux. On pourra se reporter à cette publication, incorporée ici par référence, pour plus de précisions sur ce procédé.

D'autres exemples de procédés de micro-usinage du silicium sont décrits dans l'ouvrage intitulé « Fundamentals of microfabrication », de Marc Madou, édité par CRC Press, et portant la référence ISBN 0-8493-9451-1, incorporé ici par référence, auquel on pourra se reporter pour plus de détails.

On décrit maintenant de manière simplifiée les principales étapes du procédé selon l'invention.

Sur la figure 1, on a représenté une plaque de silicium 12 avant la mise en oeuvre du procédé selon l'invention.

La figure 2 illustre une étape de dépôt d'une couche sacrificielle 14 sur la face supérieure de la plaque de silicium 12.

La figure 3 illustre le traitement de la couche sacrificielle 14, à travers un masque 16, visant à modifier localement la structure de la couche sacrificielle 14 de manière à dessiner sur la plaque de silicium 12 un motif représentant une série d'aiguilles 10.

Sur la figure 4, la couche sacrificielle 14 est développée, c'est-à-dire que les portions de couche sacrificielle 14 traitées ont été éliminées, de sorte que la couche sacrificielle 14 laisse apparaître localement des portions 18 de la face supérieure de la plaque de silicium 12.

Sur la figure 5, la plaque de silicium 12 a été gravée à travers la couche sacrificielle, de préférence selon une technique de gravage anisotrope, de sorte que le motif représentant les aiguilles 10 est maintenant dessiné dans l'épaisseur de la plaque de silicium 12.

La couche sacrificielle 14 restante est alors éliminée, comme représentée sur la figure 6.

On obtient alors une plaque de silicium 12 dans laquelle les aiguilles 10 sont prédécoupées et retenues attachées au corps de la plaque 12 par des ponts de matière, comme on l'a représenté sur les figures 7a et 7b.

L'étape finale de la fabrication des aiguilles 10 consiste à détacher les aiguilles de la plaque de silicium 12.

Avantageusement, le procédé selon l'invention peut comporter au moins une étape au cours de laquelle un revêtement, par exemple métallique, est déposé sur le silicium formant les aiguilles 10. Ce revêtement peut-être déposé selon des techniques de dépôt chimique ou physique en phase vapeur (« Chemical Vapour Déposition » ou « Physical Vapour Déposition »).

Le procédé selon l'invention peut aussi comporter une étape de traitement chimique et/ou thermique appliqué sur la surface du silicium formant les aiguilles 10, par exemple en vue de modifier l'aspect de surface du silicium.

On note que des étapes de gravage peuvent aussi être mises en oeuvre de manière à modifier l'aspect de surface du silicium, ou de manière à modifier l'aspect de surface d'un revêtement déposé sur le silicium, en réalisant des motifs géométriques ou autres, ce qui permet d'obtenir des effets optiques intéressants. De tels motifs géométriques peuvent, par exemple, donner un aspect de type guillochage à la surface des aiguilles 10 réalisées dans le silicium. De telles étapes de gravage peuvent être mises en oeuvre lorsque les aiguilles 10 sont encore portées par la plaque de silicium 12.

Selon le mode de réalisation représenté sur la figure 9, la face supérieure de l'aiguille 10 est pourvue de motifs géométriques 24 en relief qui ont été réalisés par gravage du silicium. Un dépôt métallique 26 a été réalisé sur ces motifs géométriques 24 ce qui donne à l'aiguille 10 un aspect extérieur métallique guilloché. On note qu'un tel résultat serait très difficile à obtenir dans le cas d'une aiguille 10 dont le corps principal 11 est en métal.

Selon le mode de réalisation représenté sur les figures 10 et 11, on a réalisé par gravage deux facettes 28 longitudinales dans la face supérieure de l'aiguille 10.

Selon des variantes de réalisation, les motifs 24 et les facettes 28 peuvent posséder des profils incurvés de manière à former des ondulations sur la surface de l'aiguille 10.

On note que le procédé de fabrication d'aiguilles 10 selon l'invention permet de réaliser facilement des aiguilles 10 ayant des formes et des aspects extérieurs très variés.

Avantageusement, le procédé selon l'invention peut être mis en oeuvre en parallèle sur plusieurs plaques de silicium 12, de manière à réaliser simultanément, dans plusieurs plaques de silicium 12, des aiguilles 10 de caractéristiques similaires.

Sur la figure 8, on a représenté une montre 20 qui est pourvue d'au moins une aiguille 10 en silicium réalisée conformément au procédé selon l'invention.

Chaque aiguille 10 est prévue pour être liée en rotation à un axe ou une roue du mouvement horloger (non représenté) de la montre 20. A cet effet, l'aiguille 10 est pourvue ici d'un trou d'axe 32 destiné à être chassé sur un axe d'entraînement 34.

Avantageusement, la surface axiale interne du trou d'axe 32 est pourvue d'une couche 36 de matériau destinée à permettre le chassage de l'aiguille 10 par déformation de la couche 36 ou par glissement contre la couche 36, en limitant les risques de rupture du corps principal 11.

Selon une variante de réalisation, l'aiguille 10 selon l'invention peut être collée ou soudée sur l'axe d'entraînement 34.

Selon un mode de réalisation avantageux de l'invention, qui est représenté sur la figure 9, un élément 22 de circuit intégré est réalisé dans l'épaisseur de la plaque 12 de silicium, dans le corps 11 de l'aiguille 10.

L'élément 22 de circuit intégré peut être réalisé, selon les technologies de fabrication classiques de la microélectronique, avant, pendant, ou après la mise en oeuvre du procédé de fabrication selon l'invention. Ainsi, des éléments 22 de circuit intégré peuvent être préalablement réalisés dans la plaque de silicium 12 telle que représentée sur la figure 1, à partir de laquelle les aiguilles 10 sont fabriquées.

L'élément 22 de circuit intégré peut être raccordé électriquement au circuit de commande de la montre 20, à travers l'arbre de rotation de l'aiguille 10.

L'élément 22 de circuit intégré comporte, par exemple, une diode électroluminescente intégrée dans l'épaisseur de l'aiguille 10. L'aiguille 10 peut ainsi être éclairée par l'intérieur, en exploitant les propriétés de transparence du silicium.

L'élément 22 de circuit intégré peut comporter un capteur prévu pour fournir au circuit de commande de la montre 20 des indications sur la position angulaire de l'aiguille 10 par rapport au cadran.

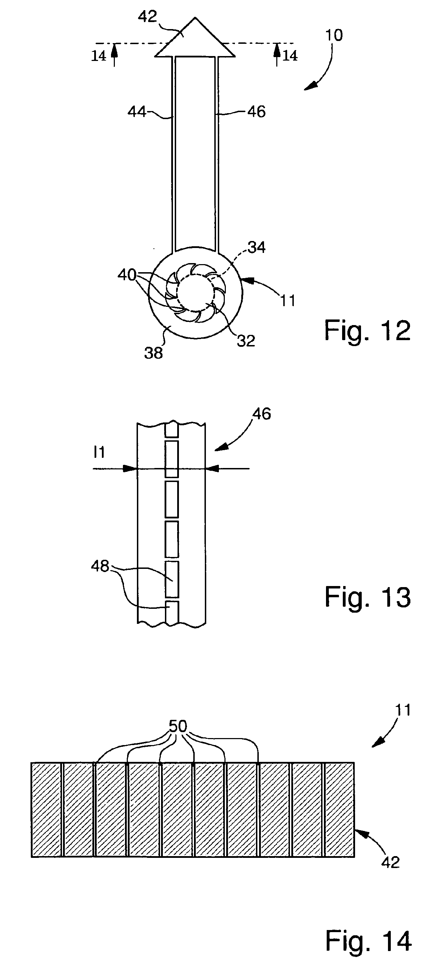

Sur les figures 12 à 14, on a représenté un mode de réalisation perfectionné dans lequel l'aiguille 10 est réalisée entièrement en silicium, c'est-à-dire que son corps principal 11, qui forme la structure mécanique de l'aiguille 10, est en silicium et définit la forme extérieure de l'aiguille 10. Bien entendu, le corps principal 11 peut être recouvert d'une ou plusieurs couches de revêtements tels que des revêtements métalliques.

Selon le mode de réalisation représenté, le corps principal 11 comporte une portion proximale 38 annulaire dans laquelle est aménagé le trou d'axe 32 devant permettre le montage de l'aiguille 10 sur l'axe d'entraînement 34 de la montre 20. Le trou d'axe 32 est prévu pour être ajusté sur l'axe d'entraînement 34, de manière que la fixation de l'aiguille 10 sur l'axe d'entraînement 34 soit similaire à un chassage.

Le trou d'axe 32 est ici pourvu d'éléments flexibles 40 en forme de languettes qui sont réalisés d'une seule pièce avec la portion proximale 38 du corps principal 11 et qui sont en saillie sur la surface interne du trou d'axe 32. Les éléments flexibles 40 sont prévus pour se déformer élastiquement lors du montage de l'aiguille 10 sur l'axe d'entraînement 34. Ainsi, après montage, les éléments flexibles 40 exercent une force de serrage sur l'axe d'entraînement 34 qui permet de retenir axialement l'aiguille 10 sur l'axe d'entraînement 34 et de lier en rotation ces deux éléments.

Les éléments flexibles 40 sont formés de préférence au cours de l'étape de micro-usinage de la plaque 12 de silicium.

Le corps principal 11 comporte aussi une portion distale 42 qui constitue le tronçon indicateur de l'aiguille 10. La portion distale 42 a ici la forme d'un triangle mais elle pourrait prendre toute autre forme adéquate en vue d'indiquer une position angulaire déterminée sur le cadran de la pièce d'horlogerie 20.

La portion distale 42 est liée à la portion proximale 38 par deux poutres 44, 46 dont la largeur I1, dans un plan transversal à l'axe d'entraînement 34, est comprise entre trente et deux cent microns, et est de préférence égale à cinquante microns. La largeur I1 de cinquante microns offre un bon compromis entre la rigidité et la finesse de la poutre 44, 46.

On obtient ainsi une aiguille 10 dont pratiquement seules la portion proximale 38 et la portion distale 42 sont visibles, lorsque l'utilisateur de la montre 20 consulte les indications donnée par l'aiguille 10, en particulier en vue de dessus. En effet, combinée avec l'épaisseur très faible, comprise par exemple entre trente et cent microns, de préférence égale à cinquante microns, la faible largeur I1 permet de rendre les poutres 44, 46 quasiment invisibles à l'oeil nu et ainsi de rendre mieux visibles les éléments situés sous l'aiguille 10, entre la portion proximale 38 et la portion distale 42, notamment des éléments affichés sur le cadran de la montre 20. De plus, l'utilisation de ces poutres 44, 46 quasiment invisibles permet d'offrir plus de liberté dans le dessin de l'aiguille 10, en dissimulant une partie de la structure de l'aiguille 10.

Bien entendu, l'aiguille 10 selon l'invention peut comporter plus de deux poutres 44, 46. Le nombre de poutres 44, 46 pourra être choisi en fonction de la forme de l'aiguille 10, notamment en fonction de la forme de la portion distale 42, en vue d'assurer une rigidité et une résistance aux chocs suffisante de l'aiguille 10.

Sur la figure 13, qui est une vue agrandie d'une poutre 46 de la figure 12, on constate que les poutres 46 peuvent être munis d'évidements 48 qui sont agencés de manière adaptée pour alléger la structure de l'aiguille 10 sans significativement pénaliser sa rigidité et sa résistance aux chocs. Les évidements 48 sont constitués ici par des ouvertures ou fenêtres qui sont alignées et réparties sur la longueur de la poutre 46 en définissant des ponts de matière entre les deux parties parallèles formant la poutre 46.

De manière avantageuse, comme on peut le voir sur la figure 14, le corps principal 11 de l'aiguille 10 comporte, dans son épaisseur axiale, une multitude de perçages 50 globalement cylindriques qui sont sensiblement parallèles à l'axe d'entraînement 34 et qui ont un diamètre inférieur à cinquante microns, de préférence un diamètre compris entre trois et dix microns. Le but de ces perçages 50 est de diminuer le balourd et l'inertie de l'aiguille 10. Comme la masse des poutres n'a que peu d'influence sur le balourd et l'inertie de l'aiguille 10, les perçages 50 sont agencés de préférence uniquement dans la portion distale 42, mais ils pourraient aussi être agencés dans les autres parties du corps principal 11.
Les perçages 50 traversent ici l'épaisseur du corps principal 11 de part en part. Ils ont des dimensions suffisamment faibles pour être invisibles à l'oeil nu pour l'utilisateur de la montre 20, de sorte qu'ils ne pénalisent pas l'aspect esthétique de l'aiguille 10.

## Revendications

1. Organe d'affichage analogique (10) destiné à équiper une pièce d'horlogerie (20), du type comportant un corps principal (11) dans lequel est aménagé un trou d'axe (32) **caractérisé en ce que** le corps principal (11) est réalisé en matériau cristallin à base de silicium et **en ce qu'**il comporte des éléments flexibles (40) qui sont réalisés d'une seule pièce avec le reste du corps principal (11) et qui s'étendent dans le trou d'axe (32) de manière à permettre l'ajustage de l'organe d'affichage analogique (10) sur un axe d'entraînement (34) par déformation élastique des éléments flexibles (40).

2. Organe d'affichage analogique (10) selon la revendication précédente, **caractérisé en ce que** le corps principal (11) a la forme d'une aiguille (10) horlogère.

3. Organe d'affichage analogique (10) selon l'une quelconque des revendications précédentes, **caractérisée en ce que** le corps principal (11) comporte, dans son épaisseur, une multitude de perçages (50) qui sont parallèles à l'axe d'entraînement (34) et qui ont un diamètre inférieur à cinquante microns.

4. Organe d'affichage analogique (10) selon l'une quelconque des revendications précédentes, **caractérisé en ce que** la surface supérieure du corps principal (11) comporte des motifs (24) en reliefs.

5. Organe d'affichage analogique (10) selon l'une quelconque des revendications précédentes, **caractérisé en ce que** la surface supérieure du corps principal (11) comporte des facettes (28).

6. Organe d'affichage analogique (10) selon l'une quelconque des revendications précédentes, **caractérisé en ce qu'**au moins une face du corps principal (11) est pourvue d'un revêtement (26) réalisé dans un matériau différent du corps principal (11).

7. Organe d'affichage analogique (10) selon la revendication précédente, **caractérisé en ce que** le revêtement (26) est réalisé en métal.

8. Organe d'affichage analogique (10) selon l'une quelconque des revendications précédentes, **caractérisé en ce qu'**il comporte au moins un élément (22) de circuit intégré qui est agencé dans l'épaisseur du corps principal (11).

9. Organe d'affichage analogique (10) selon l'une quelconque des revendications précédentes, **caractérisé en ce que** le matériau cristallin est du silicium monocristallin.

10. Pièce d'horlogerie (20) **caractérisée en ce qu'**elle comporte au moins un organe d'affichage analogique (10) selon l'une quelconque des revendications précédentes.

11. Procédé de fabrication d'organes d'affichage analogique (10) destinés à équiper des pièces d'horlogerie (20), chaque organe d'affichage analogique (10) comportant un corps principal (11) dans lequel est aménagé un trou d'axe (32) agencé pour être ajusté sur un axe d'entraînement (34), **caractérisé en ce qu'**il comporte au moins une étape de micro-usinage d'une plaque (12) en matériau cristallin à base de silicium de manière à réaliser au moins un corps principal (11) en un tel matériau cristallin avec son trou d'axe (32) et **en ce que**, au cours de l'étape de micro-usinage de la plaque (12), des éléments flexibles (40) sont formés sur le corps principal (11) pour permettre le montage de l'organe d'affichage analogique (10) sur l'axe d'entraînement (34) par déformation élastique des éléments flexibles.

12. Procédé de fabrication selon la revendication 11, **caractérisé en ce que** l'étape de micro-usinage est mise en oeuvre de manière à réaliser simultanément plusieurs organes d'affichage analogique (10) dans la même plaque (12).

13. Procédé de fabrication selon la revendication 11 ou 12, **caractérisé en ce que** l'étape de micro-usinage comporte au moins une étape lithographique visant à reproduire sur la plaque (12) les contours d'au moins une portion du corps principal (11) d'un organe d'affichage analogique (10).

14. Procédé de fabrication selon l'une quelconque des revendications 11 à 13, **caractérisé en ce qu'**il comporte au moins une étape de dépôt d'un revêtement (26) sur au moins une face du corps principal (11) de chaque organe d'affichage analogique (10).

15. Procédé de fabrication selon l'une quelconque des revendications 11 à 14, **caractérisé en ce qu'**il comporte au moins une étape de micro-usinage de la face supérieure du corps principal (11) pour y réaliser des motifs (24) en relief.

16. Procédé de fabrication selon l'une quelconque des revendications 11 à 14, **caractérisé en ce qu'**il comporte au moins une étape de micro-usinage de la face supérieure du corps principal (11) pour y réaliser des facettes (28).

17. Procédé de fabrication selon l'une quelconque des revendications 11 à 16, **caractérisé en ce que** le matériau cristallin est du silicium monocristallin.

## Claims

1. Analogue display member (10) fitted to a timepiece (20), of the type including a main body (11) in which an arbour hole (32) is made **characterized in that** the main body (11) is made of a silicon based crystalline material and **in that** the main body (11) includes flexible elements (40) which are made in a single piece with the rest of the main body (11) and which extend into the arbour hole (32) so as to allow the analogue display member (10) to be fitted onto a drive arbour (34) via resilient deformation of the flexible elements (40).

2. Analogue display member (10) according to preceding claim, **characterized in that** the main body (11) has the shape of a timepiece hand (10).

3. Analogue display member (10) according to any of the preceding claims, **characterized in that** the main body (11) includes, in the thickness thereof, a multitude of bores (50) which are parallel to the drive arbour (34) and which have a diameter smaller than fifty microns.

4. Analogue display member (10) according to any of the preceding claims, **characterized in that** the top surface of the main body (11) includes embossed patterns (24).

5. Analogue display member (10) according to any of the preceding claims, **characterized in that** the top surface of the main body (11) includes facets (28).

6. Analogue display member (10) according to any of the preceding claims, **characterized in that** at least one face of the main body (11) is provided with a coating (26) made in a different material from the main body (11).

7. Analogue display member (10) according to the preceding claim, **characterized in that** the coating (26) is made of metal.

8. Analogue display member (10) according to any of the preceding claims, **characterized in that** it includes at least one integrated circuit element (22) which is arranged in the thickness of the main body (11).

9. Analogue display member (10) according to any of the preceding claims, **characterized in that** the crystalline material is monocrystalline silicon.

10. Timepiece (20) **characterized in that** it includes at least one analogue display member (10) according to any of the preceding claims.

11. Method of fabricating analogue display members (10) to be fitted to timepieces (20), each analogue display member (10) including a main body (11) in which an arbour hole (32) is arranged to be fitted to a drive arbour (34), **characterized in that** it includes at least one step of micro-machining a wafer (12) of silicon based crystalline material to make at least one main body (11) in said crystalline material with said arbour hole (32) and **in that**, during the wafer (12) micro-machining step, flexible elements (40) are formed on the main body (11) to allow assembly of the analogue display member (10) on the drive arbour (34) via the resilient deformation of the flexible elements.

12. Fabrication method according to claim 11, **characterized in that** the micro-machining step is implemented so as to make several analogue display members (10) simultaneously in the same wafer (12).

13. Fabrication method according to claim 11 or 12, **characterized in that** the micro-machining step includes at least one lithographic step for reproducing on said wafer (12) the contours of at least one portion of the main body (11) of one analogue display member (10).

14. Fabrication method according to any of claims 11 to 13, **characterized in that** it includes at least one step of depositing a coating (26) on at least one face of the main body (11) of each analogue display member (10).

15. Fabrication method according to any of claims 11 to 14, **characterized in that** it includes at least one step of micro-machining the top face of the main body (11) to form embossed patterns (24) therein.

16. Fabrication method according to any of claims 11 to 14, **characterized in that** it includes at least one step or micro-machining the top face of the main body (11) to form facets (28) therein.

17. Fabrication method according to any of claims 11 to 16, **characterized in that** the crystalline material is monocrystalline silicon.

## Patentansprüche

1. Analoges Anzeigeorgan (10), das zur Ausrüstung eines Zeitmessgeräts (20) bestimmt ist, des Typs, der einen Hauptkörper (11) enthält, in dem ein Wellenloch (32) ausgebindet ist, **dadurch gekennzeichnet, dass** der Hauptkörper (11) aus einem kristallinem Material auf Siliciumbasis verwirklicht ist und dass es flexible Elemente (40) enthält, die einteilig mit dem Rest des Hauptkörpers (11) verwirklicht sind und in dem Wellenloch (32) in der Weise verlaufen, dass die Einstellung des analogen Anzeigeorgans (10) auf einer Antriebswelle (34) durch elastische Verformung der flexiblen Elemente (40) möglich ist.

2. Analoges Anzeigeorgan (10) nach dem vorhergehenden Anspruch, **dadurch gekennzeichnet, dass** der Hauptkörper (11) die Form eines Uhrzeigers (10) hat.

3. Analoges Anzeigeorgan (10) nach einem der vorhergehenden Ansprüche, **dadurch gekennzeichnet, dass** der Hauptkörper (11) in seiner Dickenrichtung mehrere Durchlochungen (50) aufweist, die zu der Antriebswelle (34) parallel sind und einen Durchmesser kleiner als fünfzig Mikrometer haben.

4. Analoges Anzeigeorgan (10) nach einem der vorhergehenden Ansprüche, **dadurch gekennzeichnet, dass** die obere Oberfläche des Hauptkörpers (11) reliefartige Muster (24) aufweist.

5. Analoges Anzeigeorgan (10) nach einem der vorhergehenden Ansprüche, **dadurch gekennzeichnet, dass** die obere Oberfläche des Hauptkörpers (11) Fassetten (28) aufweist.

6. Analoges Anzeigeorgan (10) nach einem der vorhergehenden Ansprüche, **dadurch** gekenntzeichnet, dass eine Fläche des Hauptkörpers (11) mit einer Beschichtung (26) versehen ist, die aus einem Material verwirklicht ist, das von jenem des Hauptkörpers (11) verschieden ist.

7. Analoges Anzeigeorgan (10) nach dem vorhergehenden Anspruch, **dadurch gekennzeichnet, dass** die Beschichtung (26) aus Metall verwirklicht ist.

8. Analoges Anzeigeorgan (10) nach einem der vorhergehenden Ansprüche, **dadurch gekennzeichnet, dass** es wenigstens ein integriertes Schaltungselement (22) umfasst, das in Dickenrichtung des Hauptkörpers (11) angeordnet ist.

9. Analoges Anzeigeorgan (10) nach einem der vorhergehenden Ansprüche, **dadurch gekennzeichnet, dass** das kristalline Material monokristallines Silicium ist.

10. Zeitmessgerät (20), **dadurch gekennzeichnet, dass** es wenigstens ein analoges Anzeigeorgan (10) nach einem der vorhergehenden Ansprüche enthält.

11. Verfahren für die Herstellung analoger Anzeigeorgane (10), die zur Ausrüstung von Zeitmessgeräten (20) bestimmt sind, wobei jedes analoge Anzeigeorgan (10) einen Hauptkörper (11) umfasst, in dem ein Wellenloch (32) ausgebildet ist und dazu ausgelegt ist, auf einer Antriebswelle (34) eingestellt zu werden, **dadurch gekennzeichnet, dass** es wenigstens einen Schritt zur Mikrobearbeitung einer Platte (12) aus einem kristallinem Material auf Siliciumbasis umfasst, derart, dass wenigstens ein Hauptkörper (11) aus einem solchen kristallinen Material mit seinem Wellenloch (32) verwirklicht wird, und dass in dem Schritt der Mikrobearbeitung der Platte (12) flexible Elemente (40) an dem Hauptkörper (11) gebildet werden, um die Montage des analogen Anzeigeorgans (10) an der Antriebswelle (34) durch elastische Verformung der flexiblen Elemente zu ermöglichen.

12. Herstellungsverfahren nach Anspruch 11, **dadurch gekennzeichnet, dass** der Mikrobearbeitungsschritt in der Weise ausgeführt wird, dass gleichzeitig mehrere analoge Anzeigeorgane (10) in derselben Platte (12) verwirklicht werden.

13. Herstellungsverfahren nach Anspruch 11 oder 12, **dadurch gekennzeichnet, dass** der Mikrobearbeitungsschritt wenigstens einen Lithographieschritt umfasst, der darauf zielt, auf der Platte (12) wenigstens die Konturen eines Abschnitts des Hauptkörpers (11) eines analogen Anzeigeorgans (10) zu reproduzieren.

14. Herstellungsverfahren nach einem der Ansprüche 11 bis 13, **dadurch gekennzeichnet, dass** es wenigstens einen Schritt des Ablagerns einer Beschichtung (26) auf wenigstens einer Fläche des Hauptkörpers (11) jedes analogen Anzeigeorgans (10) umfasst.

15. Herstellungsverfahren nach einem der Ansprüche 11 bis 14, **dadurch gekennzeichnet, dass** es wenigstens einen Schritt des Mikrobearbeitens der oberen Fläche des Hauptkörpers (11) umfasst, um dort reliefartige Muster (24) zu verwirklichen.

16. Herstellungsverfahren nach einem der Ansprüche 11 bis 14, **dadurch gekennzeichnet, dass** es wenigstens einen Schritt des Mikrobearbeitens der oberen Fläche des Hauptkörpers (11) umfasst, um dort Fassetten (28) zu verwirklichen.

17. Herstellungsverfahren nach einem der Ansprüche 11 bis 16, **dadurch gekennzeichnet, dass** das kristalline Material monokristallines Silicium ist.
